# EUROPEAN PATENT APPLICATION

(11) **EP 1 414 081 A2**
(43) Date of publication of application: **28.04.2004**
(21) Application number: 03024460.2
(22) Date of filing: 23.10.2003
(51) Int. Cl.: H01L 51/20

(54) **Organic electroluminescent device**

(30) Priority: 24.10.2002 JP 2002309278; 28.07.2003 JP 2003202145
(71) Applicant: Kabushiki Kaisha Toyota Jidoshokki, Kariya-shi, Aichi-ken (JP)
(72) Inventor: Nakagawa, Satoshi, Kariya-shi Aichi-ken (JP); Takeuchi, Kazuyoshi, Kariya-shi Aichi-ken (JP); Nagara, Yoshiaki, Kariya-shi Aichi-ken (JP)
(74) Representative: Leson, Thomas Johannes Alois, Dipl.-Ing.

(57) **Abstract**

An organic electroluminescent device of the present invention includes a substrate (11), an anode (12), an organic layer (13) having a light emitting layer (17), and a cathode (14) capable of transmitting light. The cathode has an electron injection layer (18) of calcium and a protective layer (19) of silver. The protective layer covers the surface of the electron injection layer.

## Description

### BACKGROUND OF THE INVENTION

The present invention relates to an organic electroluminescent (EL) device.

A typical organic EL device has a substrate; an anode disposed on the substrate; an organic layer, including a light emitting layer, disposed on the anode; and a cathode disposed on the organic layer. The organic EL device in which light emitted from the light emitting layer is extracted from the substrate side of the organic EL device to the outside is referred to as a bottom emission type, and the organic EL device in which the light is extracted from the side of the organic EL device opposite to the substrate side is referred to as a top emission type.

The cathode of the organic EL device is generally formed of pure metal that is relatively low in work function, such as lithium, magnesium, calcium, and aluminum, metal oxide thereof, or metal alloy thereof. The cathode may not be necessarily capable of transmitting light, for light emitted from the light emitting layer is extracted from the substrate side of the organic EL device. In Japanese Laid-Open Patent Publication Nos. 4-212287 and 9-232079, the organic EL device of the bottom emission type including an improved cathode is disclosed.

The cathode disclosed in Japanese Laid-Open Patent Publication No. 4-212287 includes an alloy layer, and a metal layer disposed on the alloy layer. The alloy layer is formed of alloy containing at least 6 mol% of alkaline metal. The metal layer is formed of metal which does not contain any alkaline metal and which has corrosion-resistance, and has a thickness of at least 50 nm.

The cathode disclosed in Japanese Laid-Open Patent Publication No. 9-232079 also includes an alloy layer, and a metal layer disposed on the alloy layer. The alloy layer is formed of alloy containing 0.5 to 5 atomic% of at least one of alkaline metal and alkaline earth metal having a work function of no more than 2.9 eV, and has a thickness of 5 to 50 nm. The metal layer is formed of metal having a work function of at least 3.0 eV, and has a thickness of 50 to 300 nm. The alloy layer is disposed in the vicinity of the organic layer as compared with the metal layer. A concentration of oxygen contained in the cathode is no more than 1 atomic%.

On the other hand, in Japanese Laid-Open Patent Publication No. 2001-43980, the organic EL device of the top emission type is disclosed. The cathode of the organic EL device includes an electron injection layer, and a transparent conductive layer disposed on the electron injection layer. The electron injection layer is formed of metal, and has a thickness of 0.5 to 20 nm. The conductive layer is formed of an indium-zinc-oxygen-based material, and has a thickness of 200 nm.

### SUMMARY OF THE INVENTION

It is an objective of the present invention to provide an organic EL device including a novel cathode.

To achieve the above objective, the present invention provides an organic electroluminescent device. The organic electroluminescent device includes a substrate, an anode, a cathode, and an organic layer. The anode and cathode are each located on or above the substrate. One of the anode and the cathode is located above the other one. The organic layer is located between the anode and the cathode. The organic layer has at least a light emitting layer. The cathode has an electron injection layer and a protective layer. The electron injection layer has a first surface and a second surface. The first and second surfaces are on opposite sides of the electron injection layer. The first surface faces the organic layer. The second surface faces away from the organic layer. The protective layer covers the second surface to protect the electron injection layer. The electron injection layer is made of pure metal, metal alloy, or a metal compound. The protective layer is made of pure metal or metal alloy. The cathode is capable of transmitting light.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1 is a schematic diagram of an organic EL device according to a first embodiment of the present invention; and
Fig. 2 is a schematic diagram of an organic EL device according to a second embodiment of the present invention.

### DETAILED DESCRIPTION OF THE PREFERRED EMBODIMENTS

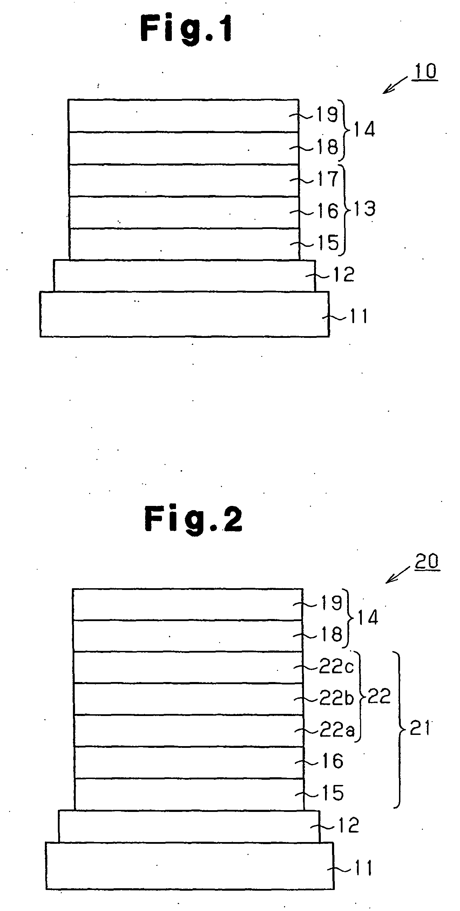

A first embodiment of the present invention will now be described with reference to Fig. 1.

As showh in Fig. 1, an organic EL device 10 includes a substrate 11, an anode 12 disposed on the substrate 11, an organic layer 13 disposed on the anode 12, and a cathode 14 disposed on the organic layer 13. The organic EL device 10, which is an organic EL device of the "top emission type", outputs light through the portion of the organic EL device 10 located on the side opposite to the substrate 11.

The substrate 11 is formed of glass and is capable of transmitting visible light. The anode 12, which is formed of chromium and has a thickness of 200 nm, reflects visible light.

The organic layer 13 includes a hole injection layer 15, a hole transport layer 16, and a light emitting layer 17. Those layers 15 to 17 are arranged in this order from the side facing the anode 12 toward the cathode 14. The hole injection layer 15 is formed of copper phthalocyanine (CuPc), and has a thickness of 10 nm. The hole transport layer 16 is formed of a tetramer of triphenylamine (TPTE) having a methyl group in a meta position of terminal phenyl, and has a thickness of 10 nm. The light emitting layer 17 is formed of an aluminum complex of an 8-quinolinol derivative, or tris(8-quinolinol)aluminum (Alq3), and has a thickness of 65 nm.

The cathode 14 is capable of transmitting visible light, and has an electron injection layer 18 and a protective layer 19. The electron injection layer 18 is formed of calcium (Ca) and has a thickness of no more than 50 nm. The protective layer 19 is formed of silver (Ag) and has a thickness of no more than 50 nm. The protective layer 19 covers the surface of the electron injection layer 18 facing away from the organic layer 13 to protect the electron injection layer 18. The electron injection layer 18 and the protective layer 19 have visible light transmittance of at least 50%, respectively. This means herein that the electron injection layer 18 and the protective layer 19 are transparent.

The thickness of the electron injection layer 18 is preferably 5 to 50 nm. In this case, the electron injection layer 18 transmits visible light very much, and the sheet resistivity of the electron injection layer 18 is not very high. The thickness of the protective layer 19 is preferably 5 to 20 nm, more preferably 7 to 11 nm. When the thickness is smaller than 5 nm, it is difficult to form a satisfactory protective layer 19; whereas when the thickness is larger than 20 nm, the protective layer 19 does not transmit visible light very much. When the thickness of the protective layer 19 is 7 to 11 nm, the protective layer 19 transmits visible light very much, and the sheet resistivity of the protective layer 19 is not very high.

The work function of calcium is 2.9 eV, and the lowest unoccupied molecular orbital (LUMO) level of Alq3 is about -3.1 eV. That is, the work function of the material forming the electron injection layer 18 is no more than the absolute value of the LUMO level of the material forming the light emitting layer 17, which is a contiguous portion and a contiguous layer of the organic layer 13 contiguous to the electron injection layer 18.

Silver, of which the protective layer 19 is formed, is an element having the lowest resistivity of the metal elements. That is, silver has resistivity lower than that of calcium, of which the electron injection layer 18 is formed. Therefore, the resistivity of the material forming the protective layer 19 is lower than that of the material forming the electron injection layer 18.

The protective layer 19 is a layer that prevents deterioration of the electron injection layer 18 such as oxidation. The material preferable for the electron injection layer 18 is generally high in reactivity. When only the electron injection layer 18 constitutes the cathode 14, deterioration, such as oxidation, easily proceeds. However, due to the protective layer 19, deterioration is inhibited.

It is to be noted that a glass cover (not shown) is disposed on the side of the organic EL device 10 opposite to the substrate 11 for the purpose of preventing the organic layer 13 from contacting oxygen or moisture.

A method for manufacturing the organic EL device 10 will now be described.

When the organic EL device 10 is manufactured, first the anode 12 is formed on the substrate 11. For the anode 12, chromium is formed into a film having a thickness of 200 nm on the substrate 11 by the sputtering method, and then the film is patterned by the etching in the photolithography process.

Next, the hole injection layer 15, hole transport layer 16, and light emitting layer 17 are successively formed on the anode 12 to provide the organic layer 13. Those layers 15 to 17 are formed by the vapor deposition under a pressure of no more than 5 × 10⁻⁵ Pa. Next, the electron injection layer 18 and protective layer 19 are successively formed on the organic layer 13 to provide the cathode 14. Both the layers 18 and 19 are formed by the vapor deposition under a pressure of no more than 5 × 10⁻⁵ Pa. The respective layers 15 to 19 are formed in the same vapor deposition apparatus. Finally, the glass cover is attached to the substrate 11, for example, in a nitrogen gas atmosphere so as to seal the anode 12, organic layer 13, and cathode 14 with the glass cover.

Operation of the organic EL device 10 will now be described.

When a direct-current voltage is applied between the anode 12 and cathode 14 of the organic EL device 10, holes are injected into the hole transport layer 16 from the anode 12 via the hole injection layer 15, and the injected holes are transported to the light emitting layer 17. On the other hand, electrons are injected into the light emitting layer 17 from the electron injection layer 18 of the cathode 14. In the light emitting layer 17, holes and electrons are recombined with each other, therefore Alq3 of the light emitting layer 17 is brought into an excited state. Alq3 emits light when returning to a basis state.

With respect to the organic EL device 10 of Fig. 1 (Example 1) and a conventional organic EL device (Comparative Example 1), light emitting characteristics were measured. Results at a current density of 11 mA/cm² are shown in Table 1. The conventional organic EL device, which is the "bottom emission type", has an anode of ITO having a thickness of 200 nm and a cathode of aluminum having a thickness of 150 nm.

**Table 1**

| | Peak wavelength (nm) | Luminance (cd/m²) | Applied voltage (V) | Power efficiency (lm/w) | Current efficiency (cd/A) |
|---|---|---|---|---|---|
| Example 1 | 540 | 1009.6 | 5.1 | 5.7 | 9.2 |
| Comparative Example 1 | 541 | 1005.2 | 5.3 | 5.4 | 9.1 |

As shown in Table 1, as compared with the conventional organic EL device, the organic EL device 10 is slightly lower in applied voltage and is superior in luminance, power efficiency, and current efficiency. Accordingly, it is apparent that the organic EL device 10 has light emitting characteristics equal to or more than those of the conventional organic EL device.

The first embodiment of the present invention provides the following advantages.

The cathode 14 is not formed of metal oxide such as ITO but of metal. Therefore, disadvantages caused by the forming of metal oxide are prevented.

The electron injection layer 18 and the protective layer 19 are thin. Therefore, even when the layers 18 and 19 are formed by vapor deposition, productivity does not drop by very much. When the layers 18 and 19 are formed by vapor deposition, a large amount of heat is not applied to the organic layer 13 at the time of forming the cathode 14, therefore, the possibility that the organic layer 13 is deteriorated, changed in properties, or otherwise damaged at the time of forming the cathode 14 is remarkably reduced.

The cathode 14 has sufficient practical resistivity, so that the cathode 14 need not be annealed. When the cathode 14 is not annealed, the organic layer 13 is not damaged by the annealing treatment that has heretofore been carried out.

It is not necessary to dispose a layer (damage preventive layer) between the organic layer 13 and the cathode 14 for preventing the organic layer 13 from being damaged at the time of forming the cathode 14. This prevents the organic layer 13 from being deteriorated at the time of forming the damage preventive layer. The drop of the light transmittance by the presence of the damage preventive layer is also prevented. Moreover, since the damage preventive layer is not provided, it is possible to form the device 10 so as to be thinner than the conventional organic EL device.

The electrons are satisfactorily injected into the light emitting layer 17 from the electron injection layer 18 because the work function of the material forming the electron injection layer 18 is not more than the absolute value of the LUMO level of the material forming the light emitting layer 17. Therefore, the light emitting efficiency in the light emitting layer 17 is improved.

The electron injection efficiency of the electron injection layer 18 into the organic layer 13 is relatively high because the material forming the electron injection layer 18 is calcium.

The visible light transmittance of the electron injection layer 18 is relatively high because the material forming the electron injection layer 18 is calcium. This improves the luminance of the organic EL device 10.

The protective layer 19 is formed to be thicker than the electron injection layer 18. Therefore, the protective layer 19 protects the electron injection layer 18 effectively as compared with a constitution in which the electron injection layer 18 is formed to be thicker than the protective layer 19.

The protective layer 19 is formed of the material having resistivity lower than that of the material forming the electron injection layer 18, and is formed to be thicker than the electron injection layer 18. Therefore, the resistance of the whole cathode 14 is lowered as compared with a constitution in which the electron injection layer 18 is formed to be thicker than the protective layer 19.

The applied voltage required for driving the organic EL device 10 is lowered as compared with the use of the other metal because silver, having the lowest resistivity of the metals, is used as the material of the protective layer 19.

The organic EL device 10 has high productivity as compared with the conventional organic EL device because either the organic layer 13 or the cathode 14 is formed by the vapor deposition in the same vapor deposition apparatus. Moreover, after forming the organic layer 13, an intermediate product does not have to be conveyed to another apparatus in order to form the cathode 14, and particles in the environment do not adhere to the surface of the organic layer 13 during the conveying.

A second embodiment of the present invention will now be described with reference to Fig. 2.

An organic EL device 20 of Fig. 2 is different from the organic EL device 10 of Fig. 1 in the constitution of the organic layer, and is the same in the constitution of other components. The components similar to those of the organic EL device 10 of Fig. 1 are denoted with the same reference numerals, and the detailed description is omitted.

As shown in Fig. 2, an organic EL device 20 includes a substrate 11, an anode 12 disposed on the substrate 11, an organic layer 21 disposed on the anode 12, and a cathode 14 disposed on the organic layer 21.

The organic layer 21 includes a hole injection layer 15, a hole transport layer 16, and a light emitting layer 22. The light emitting layer 22 includes a red light emitting layer 22a, a blue light emitting layer 22b, and a green light emitting layer 22c. Those layers 15, 16, 22a, 22b, and 22c are arranged in this order from the side facing the anode 12 toward the cathode 14.

The red light emitting layer 22a is formed of TPTE as a host and DCJT as a dopant. DCJT is represented by the following chemical formula 1. The red light emitting layer 22a contains DCJT of 0.5 wt% with respect to TPTE. The red light emitting layer 22a has a thickness of 5 nm.

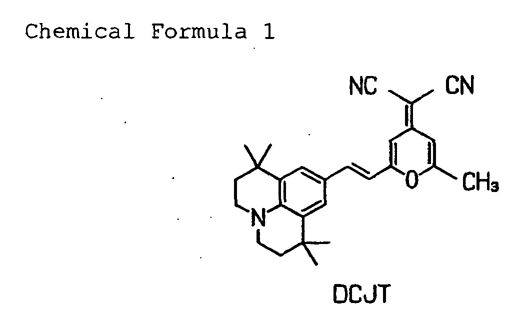

The blue light emitting layer 22b is formed of 4,4-bis(2,2-diphenyl-ethen-1-yl)-biphenyl (DPVBi) as a host and 4,4'-(bis(9-ethyl-3-carbazovinylene)-1,1'-biphenyl (BCzVBi) as a dopant. The blue light emitting layer 22b contains BCzVBi of 5.0 wt% with respect to DPVBi. The blue light emitting layer 22b has a thickness of 30 nm.

The green light emitting layer 22c is formed of Alq3 as a host and 10-(2-benzothiazolyl)-2,3,6,7-tetrahydro-1,1,7,7-tetramethyl-1H,5H,11H-[1]benzopyrano[6,7,8-ij]quinolizin-11-one (C545T) as a dopant. The green light emitting layer 22c contains C545T of 1.0 wt% with respect to Alq3. The green light emitting layer 22c has a thickness of 20 nm.

The hole injection layer 15, the hole transport layer 16, the red light emitting layer 22a, the blue light emitting layer 22b, and the green light emitting layer 22c are successively formed on the anode 12 to provide the organic layer 21. Those layers 15, 16, 22a, 22b and 22c are formed by vapor deposition under a pressure of no more than 5 × 10⁻⁵ Pa.

With respect to the organic EL device 20 of Fig. 2 (Example 2) and a conventional organic EL device (Comparative Example 2), light emitting characteristics were measured. Results at a current density of 11 mA/cm² are shown in Table 2. The conventional organic EL device, which is the "bottom emission type", has an anode of ITO having a thickness of 200 nm and a cathode of aluminum having a thickness of 200 nm.

**Table 2**

| | Peak wavelength (nm) | Luminance (cd/m²) | Applied voltage (V) | Power efficiency (lm/w) | Current efficiency (cd/A) |
|---|---|---|---|---|---|
| Example 2 | 460, 515, 600 | 1392.3 | 7.8 | 5.1 | 12.6 |
| Comparative Example 2 | 460, 520, 595 | 1305.0 | 7.5 | 5.0 | 11.9 |

As shown in Table 2, as compared with the conventional organic EL device, the organic EL device 20 is slightly higher in applied voltage and is superior in luminance, power efficiency, and current efficiency. Accordingly, it is apparent that the organic EL device 20 has light emitting characteristics equal to or more than those of the conventional organic EL device.

The second embodiment of the present invention provides the following advantages in addition to the advantage of the first embodiment.

The organic EL device 20 can be used in a full-color display when the organic EL device 20 is combined with color filters. This is because the light emitting layer 22 emits white light.

It should be apparent to those skilled in the art that the present invention may be embodied in many other specific forms without departing from the spirit or scope of the invention. Particularly, it should be understood that the invention may be embodied in the following forms.

The cathode 14 may have resistivity that is no more than that of a ITO electrode as the cathode 14 is replaced with the ITO electrode that is similar in shape and size to the cathode 14. Alternatively, the sheet resistivity of the cathode 14 may be more than 0 Ω/sheet and no more than 10 Ω/sheet. In this case, the cathode 14 need not be annealed without fail.

The present invention is not limited to be embodied in an organic EL device of the "top emission type", but may also be embodied in an organic EL device of the "bottom emission type".

The organic EL device of the bottom emission type includes a substrate; a cathode disposed on the substrate; an organic layer, including a light emitting layer, disposed on the cathode; and an anode disposed on the organic layer. The substrate and cathode is capable of transmitting light, and therefore the light emitted by the light emitting layer is outputted through the cathode and substrate. As is the case with the organic EL devices 10 and 20 of Figs. 1 and 2, the cathode of the bottom emission type has an electron injection layer and a protective layer.

The cathode of the bottom emission type may have resistivity that is no more than that of an ITO electrode as the cathode is replaced with an ITO electrode that is similar in shape and size to the cathode. Alternatively, the sheet resistivity of the cathode of the bottom emission type may be more than 0 Ω/sheet and no more than 10 Ω/sheet.

The anode of the bottom emission type may be capable of transmitting light. In this case, the light emitted by the light emitting layer is outputted through the anode as well as through the cathode and substrate.

The electron injection layer 18 may be formed of pure metal other than calcium, or metal alloy or a metal compound. Since the resistivity of pure metal and metal alloy is generally lower than that of the metal compound, the electron injection layer 18 is preferably formed of pure metal or metal alloy.

The electron injection layer 18 preferably contains alkaline metal such as lithium, sodium, potassium, rubidium, and cesium, or alkaline earth metal such as calcium, barium, strontium, and radium. That is, the electron injection layer 18 is preferably constituted of alkaline metal, alkaline earth metal, alloy containing alkaline metal or alkaline earth metal, or a metal compound containing alkaline metal or alkaline earth metal. The electron injection layer 18 is more preferably constituted of alkaline metal or alkaline earth metal. The reason for this is that alkaline metal and alkaline earth metal are low in work function as compared with the other metal.

For example, work functions of alkaline metal and alkaline earth metal are 2.93 eV for lithium, 2.28 eV for potassium, 1.95 eV for cesium, and 2.9 eV for calcium; and the work functions of the other metals are 4.28 eV for aluminum, 4.26 eV for silver, 4.5 eV for chromium, 4.65 eV for copper, 3.36 eV for magnesium, and 4.6 eV for molybdenum. Preferable alkaline metal and alkaline earth metal are lithium, potassium, cesium, and calcium in terms of availability.

The metal compound constituting the electron injection layer 18 preferably has a low work function. The metal compound has a large width in the value of the work function. The work functions of preferable metal compounds, which have relatively low work functions, are 2.24 to 4.10 eV for neodymium carbide, 3.05 to 3.98 eV for tantalum carbide, 1.66 to 6.32 eV for thorium dioxide, 2.35 to 4.09 eV for titanium carbide, 2.18 to 4.22 eV for zirconium carbide.

In a case where the electron injection layer 18 is formed of a material other than calcium, the work function of the material forming the electron injection layer 18 is preferably no more than the absolute value of the LUMO level of the light emitting layer 17 or the green light emitting layer 22c.

In a case where the electron injection layer 18 is formed of metal alloy instead of calcium, chemical stability of the electron injection layer 18 increases in many cases.

In a case where the electron injection layer 18 is formed of a material other than calcium, the material forming the electron injection layer 18 preferably has a high electron injection property. A material having a high electron injection property is, for example, pure metal.

The electron injection layer 18 may not necessarily have a uniform thickness and may have pinholes. The electron injection layer 18 is coated with the protective layer 19. Therefore, when the protective layer 19 has no pinhole, even an electron injection layer 18 having pinholes does not cause any problems. The pinholes of the electron injection layer 18 are satisfactorily compensated, when the protective layer 19 has a thickness of 7 to 11 nm.

The electron injection layer 18 may be formed in an insular shape. An electron injection layer 18 having an insular shape indicates that an average thickness of the electron injection layer 18 is no more than the thickness of a monomolecular film of the compound constituting the electron injection layer 18. When the electron injection layer 18 is constituted of a plurality of compounds, the average thickness may be no more than the average value of the thicknesses of the monomolecular film of each compound.

In a case where the protective layer 19 is formed of a material other than silver, the resistivity of the material forming the protective layer 19 is preferably lower than that of the material forming the electron injection layer 18. In comparison of alkaline metal with alkaline earth metal, alkaline earth metal has lower resistivity. For example, the resistivity of calcium is 3.91 × 10⁻⁶ Ωm, that of potassium is 6.15 × 10⁻⁶ Ωm, and that of lithium is 8.55 × 10⁻⁶ Ωm. Examples of a metal having low resistivity include silver (1.59 × 10⁻⁶ Ωm), copper (1.67 × 10⁻⁶ Ωm), aluminum (2.65 × 10⁻⁶ Ωm), and gold (2. 35 × 10⁻⁶ Ωm).

The anode 12 is an electrode for injecting the holes into the organic layer 13 or 21. Therefore, the material for forming the anode 12 is not limited as long as the properties are imparted to the anode 12. Examples of the material for forming the anode 12 include metal oxide or metal nitride such as indium-tin-oxide (ITO), indium-zinc-oxide (IZO), tin oxide, zinc oxide, zinc aluminum oxide, and titanium nitride; metal such as gold, platinum, silver, copper, aluminum, nickel, cobalt, lead, molybdenum, tungsten, tantalum, and niobium; alloy of these metals or alloy of copper iodide; conductive polymers such as polyanyline, polythiophene, polypyrole, polyphenylene vinylene, poly(3-methylthiophene), and polyphenylene sulfide. The anode 12 may be formed of only one type of the above-described materials, or may also be formed by a mixture of a plurality of materials. Moreover, the multilayered structure constituted of a plurality of layers of the same composition or different compositions may also be formed.

It is preferable that the material for forming the anode 12 has a higher work function because the holes are easily injected. Chromium has a work function of 4.5 eV, nickel has a work function of 5.15 eV, gold has a work function of 5.1 eV, palladium has a work function of 5.55 eV, ITO has a work function of 4.8 eV, and copper has a work function of 4.65 eV. A work function of the surface contacting the hole injection layer 15 of the anode 12 is preferably at least 4 eV.

When the anode 12 is disposed on the light extraction side from the light emitting layer 17, the transmittance with respect to the light to be extracted is preferably no less than 10%. When the light emitted from the light emitting layer 17 or 22 is in a visible light region, ITO is preferable for forming the anode 12 because ITO has high transmittance in the visible light region.

The anode 12 may have a capability of reflecting the light emitted from the light emitting layer 17 or 22. Examples of materials for forming the anode 12 for reflecting light include metal, alloy, and metal compounds.

Alternatively, the anode 12 may not be capable of reflecting light emitted from the light emitting layer 17 or 22. However, when the anode 12 has reflective properties, the amount of light outputted through the cathode 14 is increased as compared with a mode in which the anode 12 does not have reflective properties. This is because the light directed toward the anode 12 from the light emitting layer 17 or 22 is reflected by the anode 12 and outputted through the cathode 14. Therefore, the light emitted from the light emitting layer 17 or 22 is efficiently outputted through the cathode 14, and power consumption can be reduced.

When the resistance of the anode 12 is high, an auxiliary electrode may be disposed to lower the resistance. The auxiliary electrode is an electrode in which metal or a laminate of metal such as copper, chromium, aluminum, titanium, aluminum alloy, and silver alloy are partially disposed in the anode 12.

The anode 12 may be formed by the known thin-film forming methods such as a sputtering process, an ion plating method, a vacuum vapor deposition method, a spin coating method, and an electron beam vapor deposition method. In order to clean the surface of the anode 12, UV ozone cleaning or plasma cleaning may also be carried out. When plasma cleaning is carried out, the work function of the surface of the anode 12 can be changed. In order to inhibit short-circuits or generation of defects of the organic EL device 10 or 20, by a method of miniaturizing a par diameter or a method of polishing the formed film, roughness of the surface of the anode 12 may be controlled to be no more than 20 nm as a square average value.

The thickness of the anode 12 is preferably 5 nm to 1 µm, especially preferably 10 nm to 1 µm, more preferably 10 nm to 500 nm, yet more preferably 10 nm to 300 nm, most preferably 10 to 200 nm.

The sheet resistivity of the anode 12 is preferably several hundreds of Ω/sheet or less, more preferably 5 to 50 Ω/sheet.

The substrate 11 may not be transparent. However, when the substrate 11 is disposed on the light extraction side from the light emitting layer 17 or 22, the substrate 11 is formed to be transparent with respect to the light emitted from the light emitting layer 17 or 22.

The substrate 11 may be formed of a hard material such as metal and ceramic, or a flexible material such as resin. The substrate 11 is a generally plate-like member. Since each layer constituting the organic EL device 10 or 20 is very thin, the substrate 11 is disposed to support the organic EL device 10 or 20. The substrate 11 is a member on which the layers are laminated, and therefore preferably has a plane flatness. Example of the substrate 11 include a glass substrate, a silicon substrate, a ceramic substrate such as a quartz substrate, a plastic substrate, a metal substrate, and a composite substrate such as a substrate in which a metal foil is formed on a support member.

The constitution of the organic layer 13 or 21 is not limited to the constitution including the hole injection layer 15, the hole transport layer 16, and the light emitting layer 17 or 22 as in organic EL devices 10 and 20 of Figs. 1 and 2. For example, one or both of the hole injection layer 15 and the hole transport layer 16 may be eliminated. Alternatively, a mixed layer of a hole injection material and a hole transport material may be disposed between the anode 12 and the light emitting layer 17 or 22. Even more alternatively, an electron transport layer may also be disposed between the light emitting layer 17 or 22 and the electron injection layer 18.

More concretely, the organic layer 13 may have, for example, the following layer constitution.
(1) hole injection layer/hole transport layer/light emitting layer/electron transport layer/electron injection layer;
(2) hole injection layer/hole transport layer/light emitting layer/electron injection transport layer;
(3) hole injection transport layer/light emitting layer/electron transport layer/electron injection layer;
(4) hole injection transport layer/light emitting layer/electron injection transport layer;
(5) hole transport layer/light emitting layer/electron transport layer/electron injection layer;
(6) hole transport layer/light emitting layer/electron injection transport layer;
(7) light emitting layer/electron transport layer/electron injection layer;
(8) light emitting layer/electron injection transport layer; or
(9) light emitting layer

The layers in each of the examples of the organic layer 13 are arranged in order from the side facing the anode 12 toward the cathode 14. It is to be noted that the electron injection layer in the examples of the organic layer 13 is different from the electron injection layer of the cathode 14. The electron injection layer of the organic layer 13 is into which the electrons are injected from the cathode 14.

Each of functions required for the organic layer 13 may be realized by either a single layer or a plurality of layers in the organic layer 13. The functions include a function of being injected with electrons from the cathode 14, a function of being injected with holes from the anode 12, a function of transporting at least one of the electrons and the holes, and a function of emitting light.

Naturally, the organic materials forming the hole injection layer 15, the hole transport layer 16, and the light emitting layers 17 and 22 are not limited to those described in the first and second embodiments.

Instead of CuPc, the hole injection layer 15 may be formed of a dimer of triphenylamine (TPD) or a compound wherein two phenyl groups of TPD have been replaced with naphthyl groups.

Instead of TPTE, the hole transport layer 16 may be formed of trinitrofluorenone (TNF) or a compound having an oxadiazole or triazole structure.

The light emitting layer 17 or 22 may be formed of a material other than the materials in the above-described embodiments.

An example will hereinafter be described in which the organic layer 13 or 21 is constituted of a hole injection transport layer, a light emitting layer, and an electron injection transport layer, and a case where another constitution is employed will also be described.

### <<Hole Injection Transport Layer>>

The hole injection transport layer, into which holes are injected from the anode and which transports the injected holes into the light emitting layer, is disposed between the anode and the light emitting layer. An ionization potential of the hole injection transport layer, which is set to be between the work function of the anode and an ionization potential of the light emitting layer, is usually set at 5.0 to 5.5 eV.

The organic EL device including the hole injection transport layer has the following properties.
(1) Driving voltage is low.
(2) Injection of holes into the light emitting layer from the anode is stabilized. Therefore, life of the device is extended.
(3) Adhesion between the anode and the light emitting layer increases. Therefore, uniformity of the light emitting surface is improved.
(4) Protrusions on the surface of the anode are coated. Therefore, device defects can be reduced.

When the light emitted by the light emitting layer is outputted through the hole injection transport layer, the hole injection transport layer is formed to transmit the emitted light. Among the materials that can form the hole injection transport layer, the material transmitting the emitted light is appropriately selected when being formed into a thin film. In general, the transmittance of the hole injection transport layer with respect to the emitted light is preferably higher than 10%. The material for forming the hole injection transport layer is not especially limited as long as the above-described properties are imparted to the hole injection transport layer. A material can be arbitrarily selected and used from the known materials used as the hole injection material of the photoconductive device and the known materials used in the hole injection transport layer of a conventional organic EL device.

Examples of the material for forming the hole injection transport layer include phthalocyanine derivatives, triazole derivatives, triarylmethane derivatives, triarylamine derivatives, oxazole derivatives, oxadiazole derivatives, stilbene derivatives, pyrazoline derivatives, pyrazolone derivatives, polysilane derivatives, imidazole derivatives, phenylenediamine derivatives, amino substituted chalcone derivatives, styrylanthracene derivatives, fluorenone derivatives, hydrazone derivatives, silazane derivatives, aniline copolymer, porphyrin compounds, polyarylalkane derivatives, polyphenylene vinylene and derivatives thereof, polythiophene and derivatives thereof, poly-N-vinylcarbazole derivatives, electroconductive polymeric oligomers such as thiophene oligomer, carbazole derivatives, quinacridone compounds, aromatic tertiary amine compounds, styrylamine compounds, and aromatic dimethylidene-based compounds.

Examples of the triarylamine derivatives include a dimer to tetramer of triphenylamine, 4,4'-bis[N-phenyl-N-(4''-methylphenyl)amino]biphenyl, 4,4'-bis[N-phenyl-N-(3''-methylphenyl)amino]biphenyl, 4,4'-bis[N-phenyl-N-(3''-methoxyphenyl)amino]biphenyl, 4,4'-bis[N-phenyl-N-(1''-naphthyl)amino]biphenyl, 3,3'-dimethyl-4,4'-bis[N-phenyl-N-(31''-methylphenyl)amino]biphenyl, 1,1-bis[4'-[N,N-di(4''-methylphenyl)amino]phenyl]cyclohexane, 9,10-bis[N-(4'-methylphenyl)-N-(4''-n-butylphenyl)amino]phenanthrene, 3,8-bis(N,N-diphenylamino)-6-phenylphenanthridine, 4-methyl-N,N-bis[4'',4'''-bis[N',N''-di(4-methylphenyl)amino]biphenyl-4-yl]aniline, N,N''-bis[4-(diphenylamino)phenyl]-N,N'-diphenyl-1,3-diaminebenzene, N,N'-bis[4-(diphenylamino)phenyl]-N,N'-diphenyl-1,4-diaminobenzene, 5,5''-bis[4-(bis[4-methylphenyl]amino)phenyl]-2,2':5',2''-terthiophene), 1,3,5-tris(diphenylamino)benzene, 4,4',4''-tris(N-carbazolyl)triphenylamine, 4,4',4''-tris[N-(3'''-methylphenyl)-N-phenylamino]triphenylamine, 4,4',4''-tris[N,N-bis(4'''-tert-butylbiphenyl-4''''-yl)amino]triphenylamine, and 1,3,5-tris[N-(4'-diphenylaminophenyl)-N-phenylamino]benzene.

Examples of the porphyrin compounds include porphine, 1,10,15,20-tetraphenyl-21H,23H-porphine copper(II), 1,10,15,20-tetraphenyl-21H,23H-porphine zinc(II), and 5,10,15,20-tetrakis(pentafluorophenyl)-21H,23H-porphine.

Examples of the phthalocyanine derivatives include silicon phthalocyanine oxide, aluminum phthalocyanine chloride, phthalocyanine(metal-free), dilithium phthalocyanine, copper tetramethyl phthalocyanine, copper phthalocyanine, chromium phthalocyanine, zinc phthalocyanine, lead phthalocyanine, titanium phthalocyanine oxide, magnesium phthalocyanine, and copper octamethyl phthalocyanine.

Examples of the aromatic tertiary amine compounds and styrylamine compounds include N,N,N',N'-tetraphenyl-4,4'-diaminophenyl, N,N'-diphenyl-N,N'-bis-(3-methylphenyl)-[1,1'-biphenyl]-4,4'-diamine, 2,2-bis(4-di-p-tolylaminophenyl)propane, 1,1-bis(4-di-p-tolylaminophenyl)cyclohexane, N,N,N',N'-tetra-p-tolyl-4,4'-diaminophenyl, 1,1-bis(4-di-p-tolylaminophenyl)-4-phenylcyclohexane, bis(4-dimethylamino-2-methylphenyl)phenylmethane, bis(4-di-p-tolylaminophenyl)phenylmethane, N,N'-diphenyl-N,N'-di(4-methoxyphenyl)-4,4'-diaminobiphenyl, N,N,N',N'-tetraphenyl-4,4'-diaminophenyl ether, 4,4'-bis(diphenylamino)quadriphenyl, N,N,N-tri(p-tolyl)amine, 4-(di-p-tolylamino)-4'-[4(di-p-tolylamino)styryl]stilbene, 4-N,N-diphenylamino-(2-diphenylvinyl)benzene, 3-methoxy-4'-N,N-diphenylamino stilbenzene, and N-phenylcarbazole.

Examples of carbazole derivatives include carbazole biphenyl, N-methyl-N-phenylhydrazone-3-methylidene-9-ethylcarbazole, polyvinylcarbazole, N-isopropylcarbazole, and N-phenylcarbazole.

The hole injection transport layer may be formed of one of the above-described materials, or may be formed of a mixture of a plurality of the above-described materials. Furthermore, the hole injection transport layer may have a multilayered structure constituted of a plurality of layers of the same composition or different compositions.

The hole injection transport layer is formed on the anode by the known thin-film forming methods such as a vacuum vapor deposition method, a spin coating method, a casting method, and a LB method. The thickness of the hole injection transport layer is preferably 5 nm to 5 µm.

### <<Light Emitting Layer>>

The light emitting layer is constituted mainly of an organic material. The holes and electrons are injected into the light emitting layer on the sides of the anode and the cathode, respectively. The light emitting layer transports at least one of the holes and electrons to recombine the hole and electron, makes the exciton to obtain the excited state, and emits light when returning to the basis state.

Therefore, the organic material for forming the light emitting layer includes the following functions:
(1) a function capable of injecting holes from the hole injection transport layer or the anode;
(2) a function capable of injecting electrons from the electron injection transport layer or cathode;
(3) a function of transporting at least one of the injected holes and electrons by force of an electric field;
(4) a function of recombining the electrons and holes to produce the excited state (exciton); and
(5) a function of producing the light when returning to the basis state from the excited state.

Representative examples of the material having the above-described functions include Alq3 and Be-benzoquinolinol (BeBq2). Other examples of the material include benzoxazole based fluorescent whitening agents such as 2,5-bis(5,7-di-t-pentyl-2-benzoxazolyl)-1,3,4-thiadiazole, 4,4'-bis(5,7-pentyl-2-benzoxazolyl)stilbene, 4,4'-bis[5,7-di-(2-methyl-2-butyl)-2-benzoxazolyl]stilbene, 2,5-bis(5,7-di-t-pentyl-2-benzoxazolyl)thiophine, 2,5-bis([5-α,α-dimethylbenzyl]-2-benzoxazolyl)thiophene, 2,5-bis[5,7-di-(2-methyl-2-butyl)-2-benzoxazolyl]-3,4-diphenylthiophene, 2,5-bis(5-methyl-2-benzoxazolyl)thiophene, 4,4'-bis(2-benzoxazolyl)bephenyl, 5-methyl-2-[2-[4-(5-methyl-2-benzoxazolyl)phenyl]vinyl]benzoxazolyl, and 2-[2-(4-chlorophenyl)vinyl]naphtho[1,2-d]oxazole; benzothiazole based fluorescent whitening agents such as 2,2'-(p-phenylene divinylene)-bisbenzothiazole; benzimidazole based fluorescent whitening agents such as 2-[2-[4-(2-benzimidazolyl)phenyl]vinyl]benzimidazole and 2-[2-(4-carboxyphenyl)vinyl]benzimidazole; 8-hydroxyquinoline based metallic complexes such as bis(8-quinolinol)magnesium, bis(benzo-8-quinolinol)zinc, bis(2-methyl-8-quinolinolato)aluminium oxide, tris(8-quinolinol)indium, tris(5-methyl-8-quinolinol)aluminium, 8-quinolinol lithium, tris(5-chloro-8-quinolinol)gallium, bis(5-chloro-8-quinolinol)calcium, and poly[zinc-bis(8-hydroxy-5-quinolinonyl)methane]; metal chelate oxynoid compounds such as dilithium epinedridione; styryl benzene based compounds such as 1,4-bis(2-methylstyryl)benzene, 1,4-(3-methylstyryl)benzene, 1,4-bis(4-methylstyryl)benzene, distyrylbenzene, 1,4-bis(2-ethylstyryl)benzene, 1,4-bis(3-ethylstyryl)benzene, and 1,4-bis(2-methylstyryl)2-methylbenzene; distyrylpyrazine derivatives such as 2,5-bis(4-methylstyryl)pyrazine, 2,5-bis(4-ethylstyryl)pyrazine, 2,5-bis[2-(1-naphthyl)vinyl]pyrazine, 2,5-bis(4-methoxystyryl)pyrazine, 2,5-bis[2-(4-biphenyl)vinyl]pyrazine, and 2,5-bis[2-(1-pyrenyl)vinyl]pyrazine; naphtalimide derivatives; perylene derivatives; oxadiazole derivatives; aldazine derivatives; cyclopentadiene derivatives; styrylamine derivatives; coumarin based derivatives; aromatic dimethylidine derivatives; anthracene; salicylate; pyrene; coronene; and phosphorescence luminescent materials such as fac-tris(2-phenylpyridine)iridium, bis(2-phenylpyridinato-N,C2')iridium(acetyl acetonate), 6-di(fluorophenyl)-pyridinate-N,C2')iridium(acetyl acetonate), iridium(III) bis[4,6-di(fluorophenyl)-pyridinate-N,C2']picolinate, platinum(II) (2-(4',6'-difluorophenyl)pyridinate N,C2')(2,4-pentadionate), platinum(II) (2-(4',6'-difluorophenyl)pyridinate N,C2')(6-methyl-2,4-heptadionate-O, O) and bis(2-(2'-benzo[4,5-a]thienyl)pyridinate-platinum(II) (2-(4',6'-difluorophenyl)pyridinate N,C3')iridium(acetyl acetonate).

The light emitting layer may contain a host and a dopant. The host is injected with the carrier, and is brought into the excited state by the recombination of the holes and electrons. The host brought into the excited state moves an excitation energy to the dopant. The dopant produces the light when returning to the basis state. Alternatively, the host transports the carrier into the dopant, the recombination of the holes and electrons is carried out in the dopant, and the dopant produces the light when returning to the basis state.

Examples of the material contained in the host include distyrylarylene derivatives, distyrylbenzene derivatives, distyrylamine derivatives, quinolinolato based metal complex, triarylamine derivatives, azomethine derivatives, oxadiazole derivatives, pyrazoloquinoline derivatives, silole derivatives, naphthalene derivatives, anthracene derivatives, dicarbazole derivatives, perylene derivatives, oligothiophene derivatives, coumarin derivatives, pyrene derivatives, tetraphenyl butadiene derivatives, benzopyran derivatives, europium complex, rubrene derivatives, quinacridone derivatives, triazole derivatives, benzoxazole derivatives, and benzothiazole derivatives.

The dopant is generally comprised of a fluorescent material or a phosphorescent material.

The fluorescent material is a material having fluorescent properties, and emits light in shifting to the basis state from the excited state. The fluorescent material shifts to the basis state when obtaining the energy from the host, and can extract the light emission from a singlet in the excited state at room temperature. Alternatively, the fluorescent material shifts to the excited state when the holes and electrons transported from the host recombine with each other, and emits light in returning to the basis state. It is preferable that the fluorescent material has high fluorescent quantum efficiency. An amount of the fluorescent material with respect to that of the host is preferably at least 0.01% by weight and is preferably no more than 20% by weight.

Examples of the fluorescent material include europium complex, benzopyran derivatives, rhodamine derivatives, benz thioxanthene derivatives, porphyrin derivatives, coumarin derivatives, europium complex, rubrene derivatives, nailered, 2-(1,1-dimethylethyl)-6-(2-(2,3,6,7-tetrahydro-1,1,7,7-tetramethyl-1H,5H-benzo(ij)quinolidin-9-yl)ethenyl)-4H-pyran-4H-ylidene)prbpanedinitrile (DCJTB), DCM, coumarin derivatives, quinacridone derivatives, distyrylamine derivatives, pyrene derivatives, perylene derivatives, anthracene derivatives, benzoxazole derivatives, benzothiazole derivatives, benzimidazole derivatives, chrysene derivatives, phenanthrene derivatives, distyrylbenzene derivatives, tetraphenylbutadiene derivatives, and rubrene derivatives.

Examples of the coumarin derivatives include a compound represented by the following Chemical Formula 2.

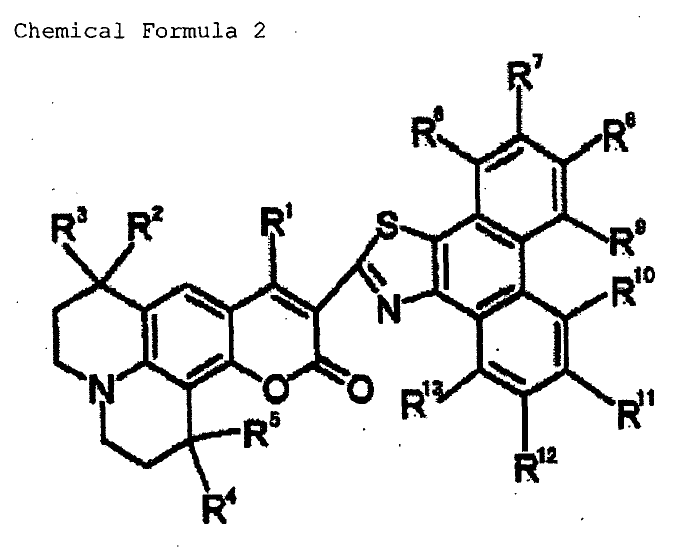

In Chemical Formula 2, R¹ to R⁵ each independently represent a hydrogen atom or a hydrocarbon group, and the hydrocarbon group may include one or a plurality of substituents. Examples of a preferable hydrocarbon group in R¹ to R⁵ include a short chain aliphatic hydrocarbon group having up to five carbon numbers such as methyl group, ethyl group, propyl group, isopropyl group, isopropenyl group, 1-propenyl group, 2-propenyl group, butyl group, isobutyl group, sec-butyl group, tert-butyl group, 2-butenyl group, 1,3-butadienyl group, pentyl group, isopentyl group, neopentyl group, tert-pentyl group, and 2-pentenyl group; an alicyclic hydrocarbon group such as cyclopropyl group, cyclobutyl group, cyclopentyl group, cyclohexyl group, and cyclohexenyl group; an aromatic hydrocarbon group such as phenyl group, o-tolyl group, m-tolyl group, p-tolyl group, xylyl group, mesityl group, o-cumenyl group, m-cumenyl group, p-cumenyl group, and biphenylyl group. One or a plurality of hydrogen atoms in the hydrocarbon group may be substituted, for example, by an ether group such as methoxy group, ethoxy group, propxy group, isopropoxy group, butoxy group, isobutoxy group, sec-butoxy group, tert-butoxy group, pentyloxy group, isopentyloxy group, phenoxy group, and benzyloxy group; an ester group such as acetoxy group, bezoyloxy group, methoxycarbonyl group, ethoxycarbonyl group, and propoxycarbonyl group; a halogen group such as fluoro group, chloro group, bromo group, and iodo group. Depending on the application of the organic EL device, a preferable coumarin derivative is in which R² to R⁵ are all aliphatic hydrocarbon groups. Especially, a coumarin derivative in which R² to R⁵ are all methyl groups is superior in both physical properties and economical efficiency.

In Chemical Formula 2, R⁶ to R¹³ each independently represent a hydrogen atom or a substituent. Examples of a substituent in R⁶ to R¹³ include an aliphatic hydrocarbon group having up to 20 carbon numbers such as methyl group, ethyl group, propyl group, isopropyl group, isopropenyl group, 1-propenyl group, 2-propenyl group, butyl group, isobutyl group, sec-butyl group, tert-butyl group, 2-butenyl group, 1,3-butadienyl group, pentyl group, isopentyl group, neopentyl group, tert-pentyl group, 1-methylpentyl group, 2-methylpentyl group, 2-pentenyl group, hexyl group, isohexyl group, 5-methylhexyl group, heptyl group, octyl group, nonyl group, decyl group, undecyl group, dodecyl group, and octadecyl group; an alicyclic hydrocarbon group such as cyclopropyl group, cyclobutyl group, cyclopentyl group, cyclohexyl group, cyclohexenyl group, and cycloheptyl group; an aromatic hydrocarbon group such as phenyl group, o-tolyl group, m-tolyl group, p-tolyl group, xylyl group, mesityl group, o-cumenyl group, m-cumenyl group, p-cumenyl group, benzyl group, phenethyl group, and biphenylyl group; an ether group such as methoxy group, ethoxy group, propoxy group, isopropoxy group, butoxy group, isobutoxy group, sec-butoxy group, tert-butoxy group, pentyloxy group, phenoxy group, and benzyloxy group; an ester group such as methoxycarbonyl group, ethoxycarbonyl group, propoxycarbonyl group, acetoxy group, and benzoyloxy group; a halogen group such as fluoro group, chloro group, bromo group, and iodo group; hydroxy group; carboxy group; cyano group; and nitro group.

More concrete examples of the coumarin derivatives include compounds represented by the following Chemical Formulas 3 to 26. In general, the coumarin derivatives including the compounds represented by the Chemical Formulas 3 to 26 are high in melting point and glass transition temperature. As a result, the coumarin derivatives have high thermal stability.

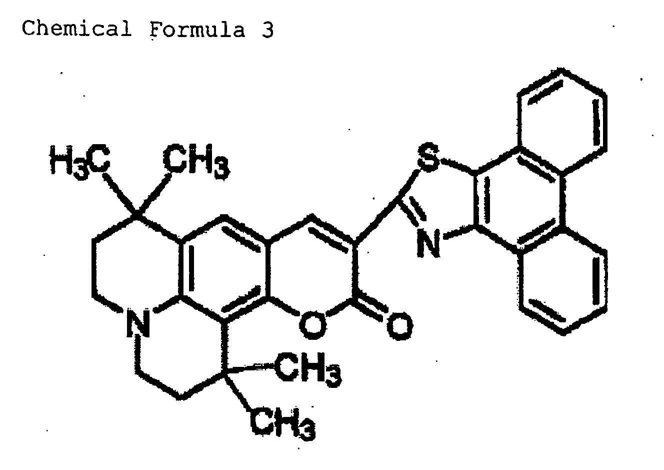

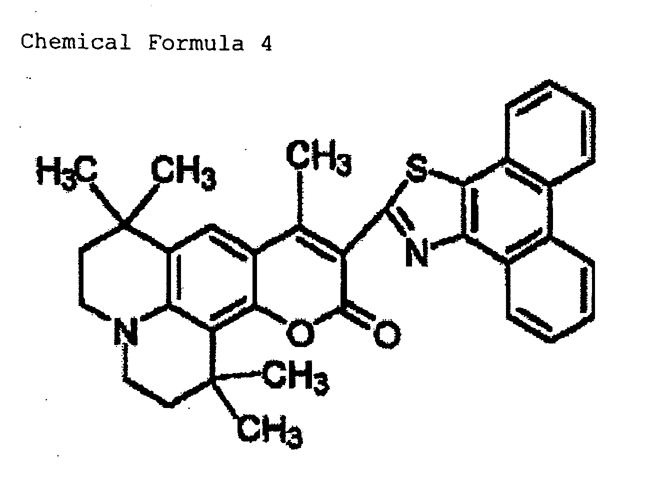

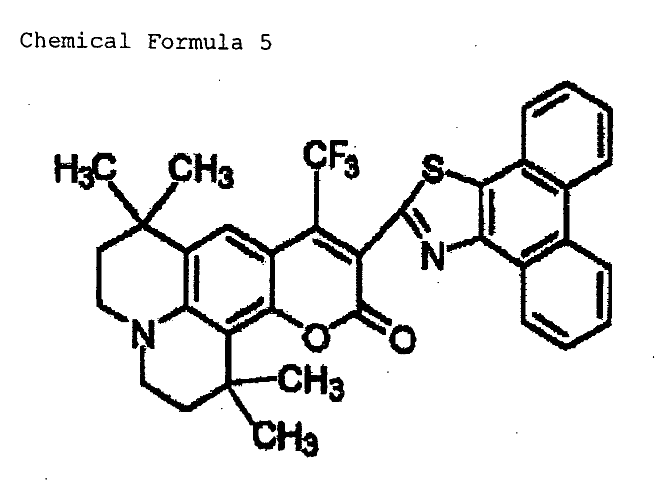

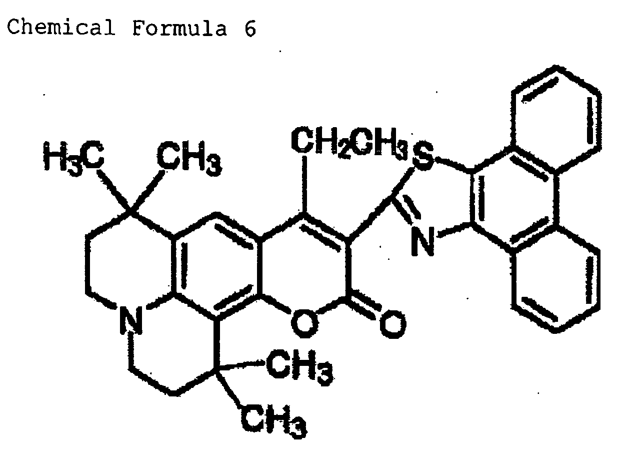

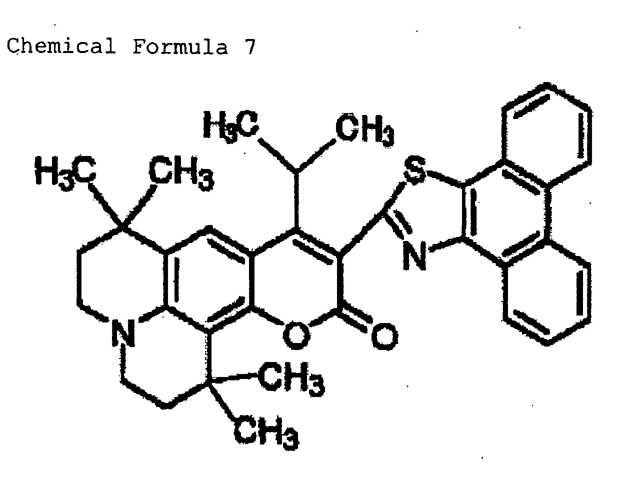

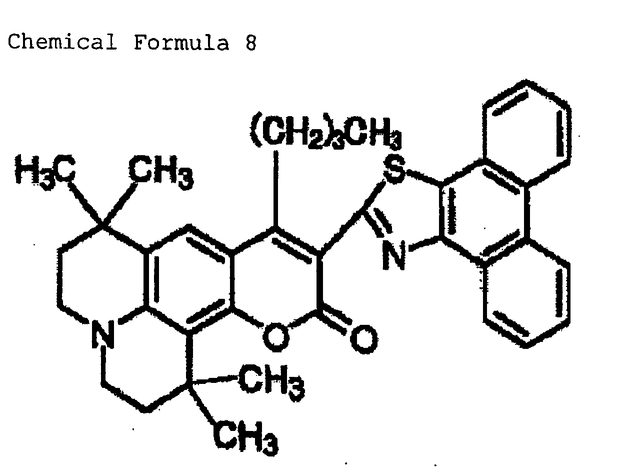

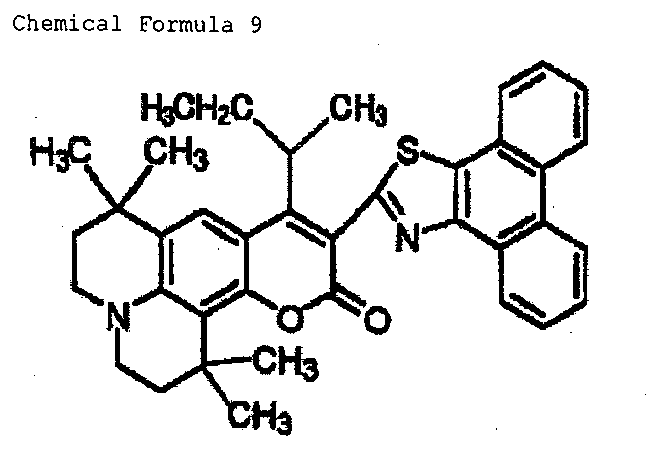

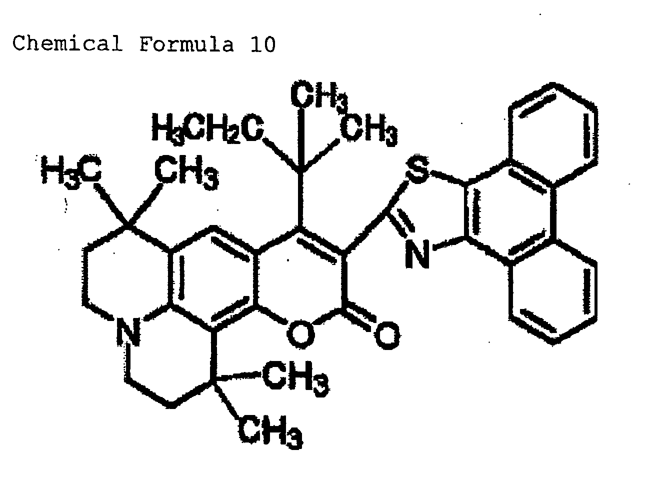

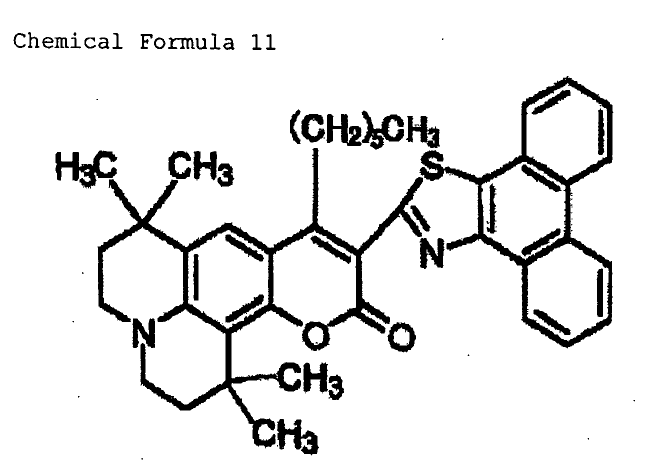

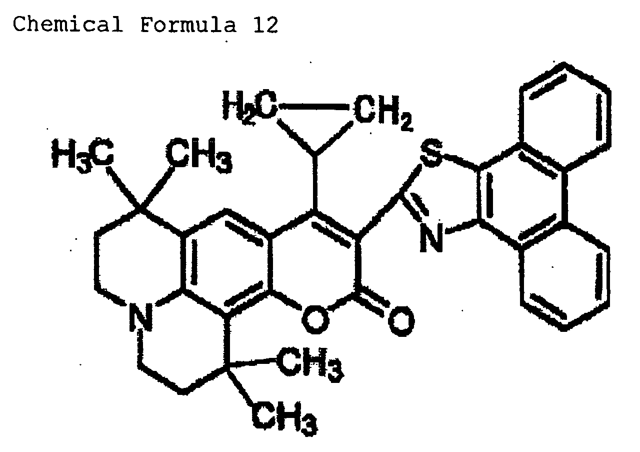

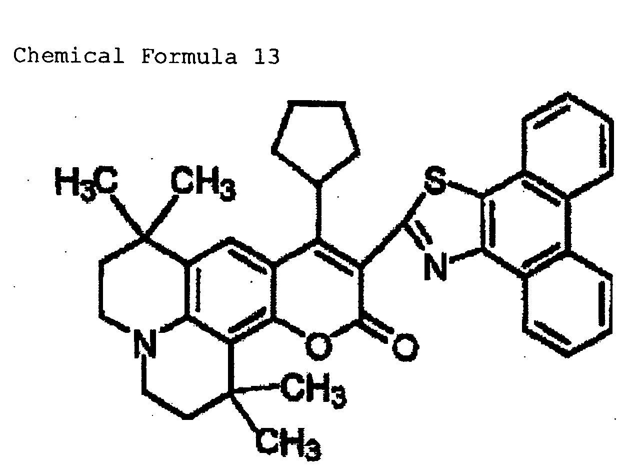

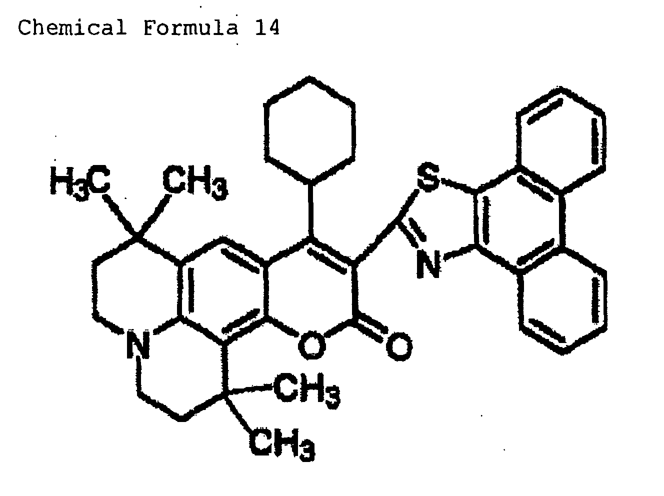

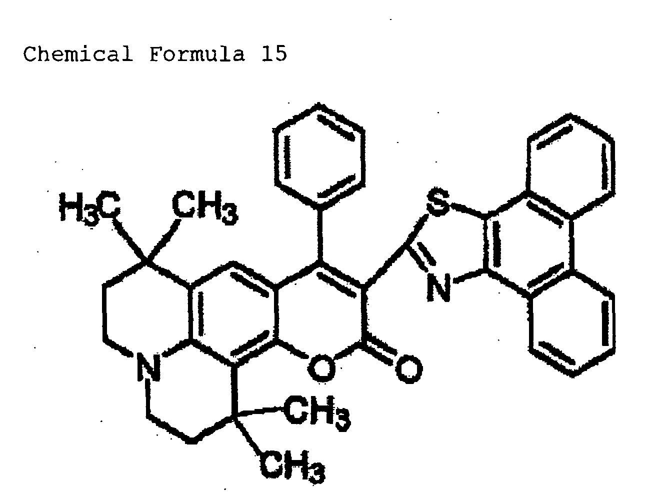

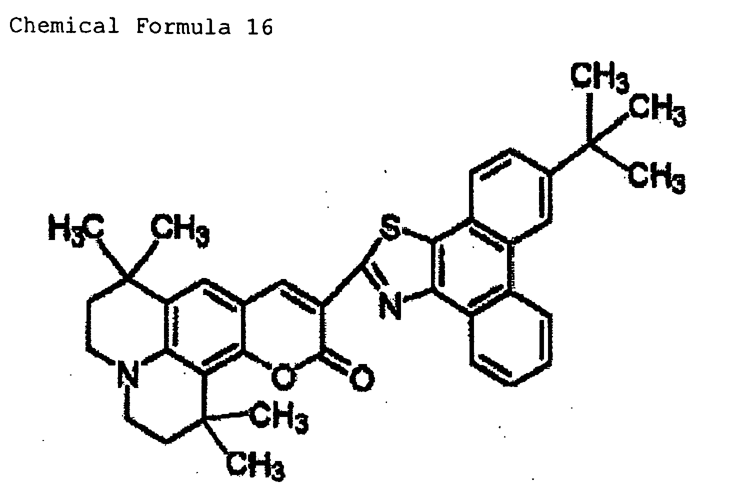

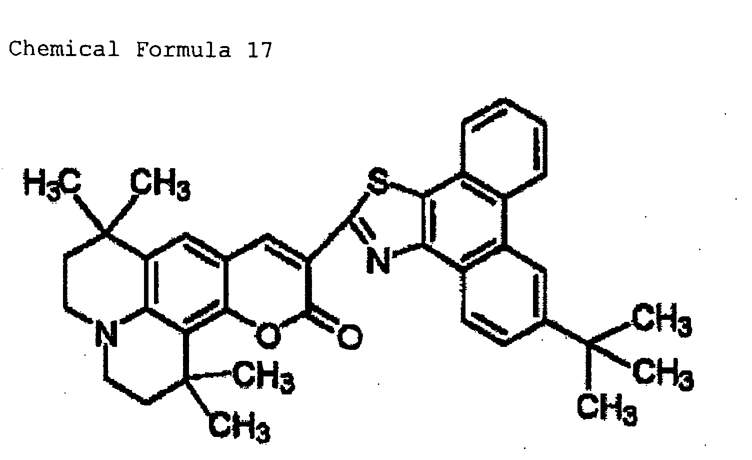

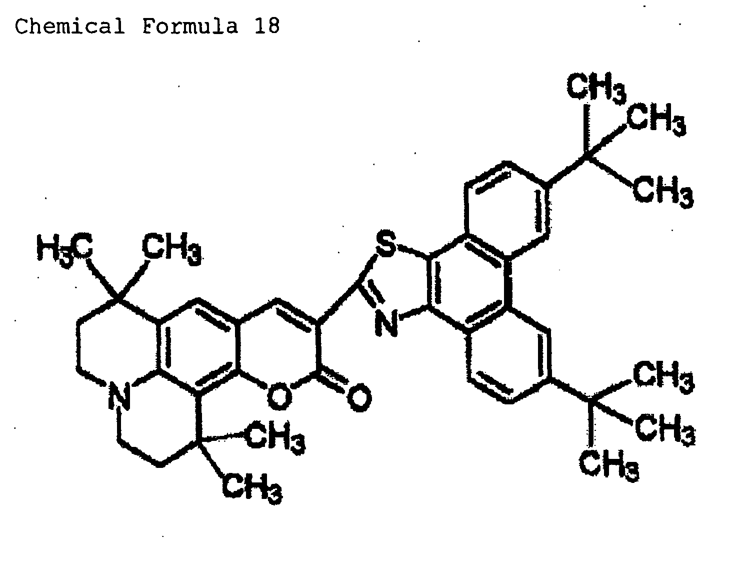

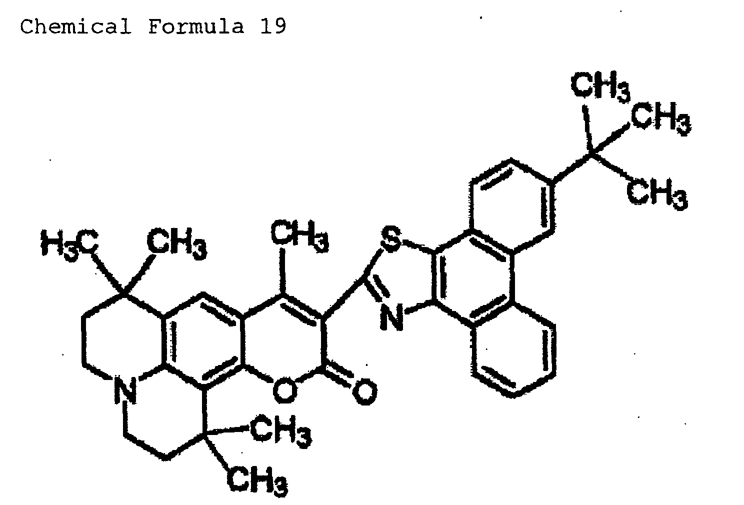

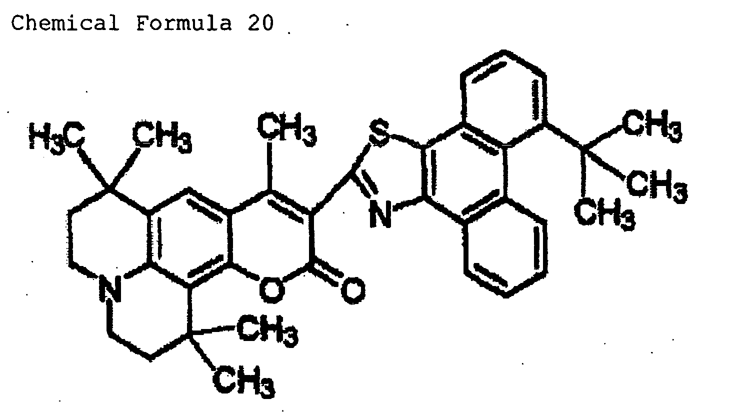

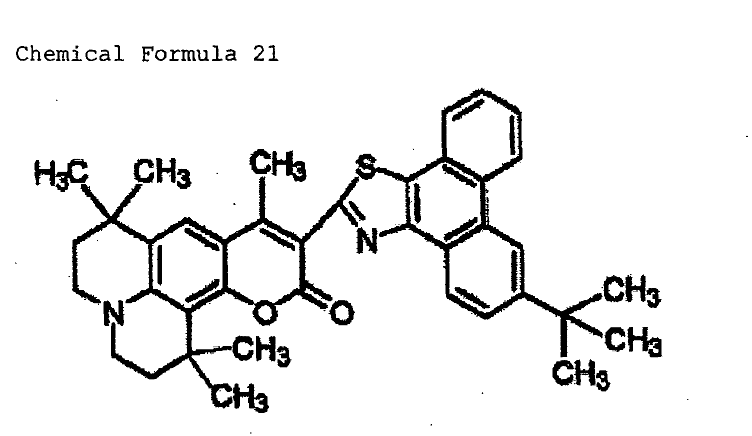

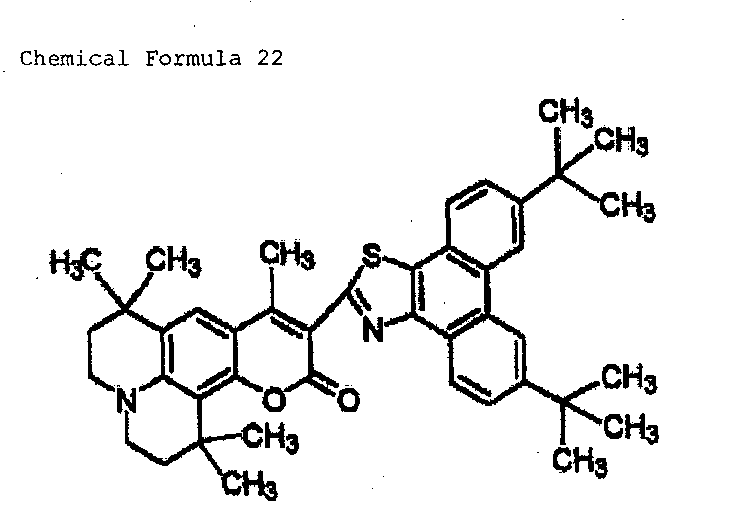

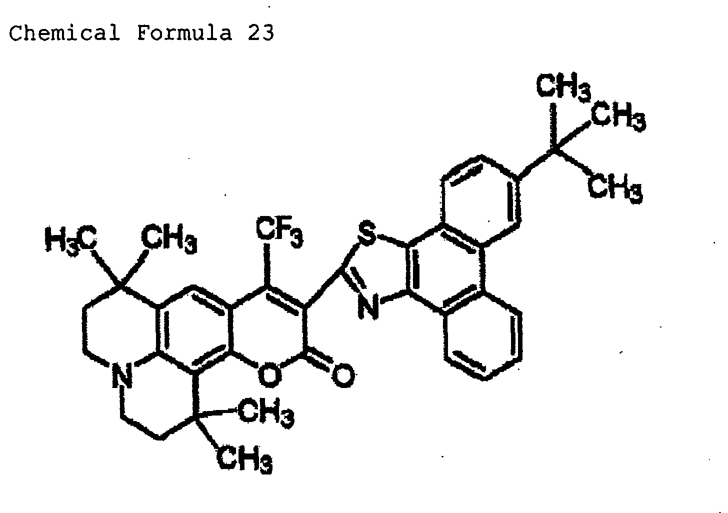

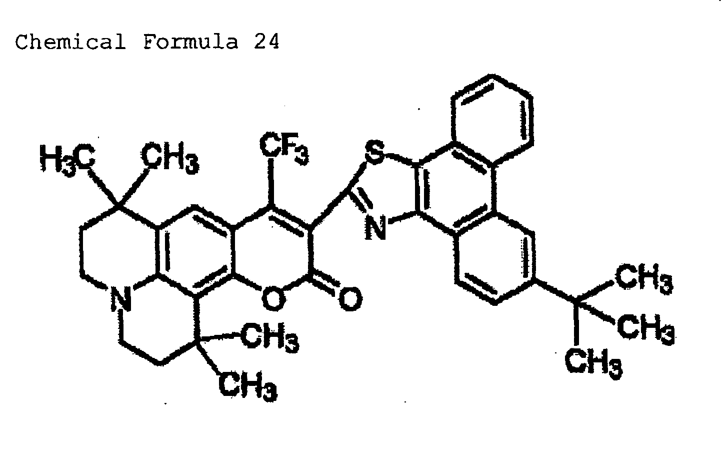

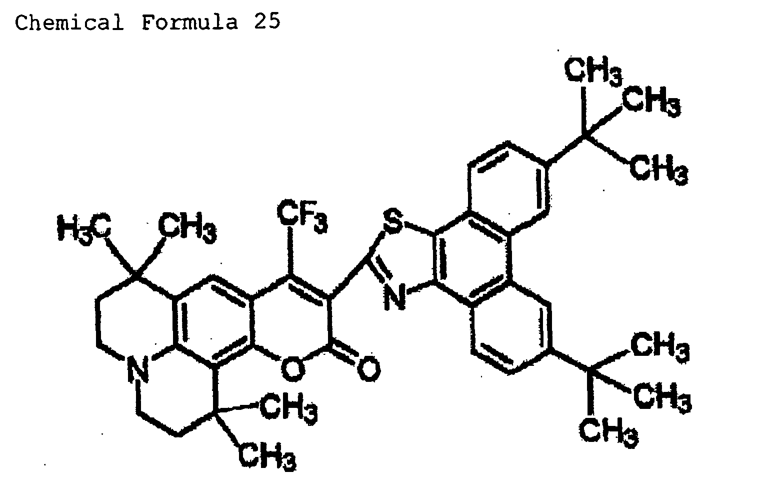

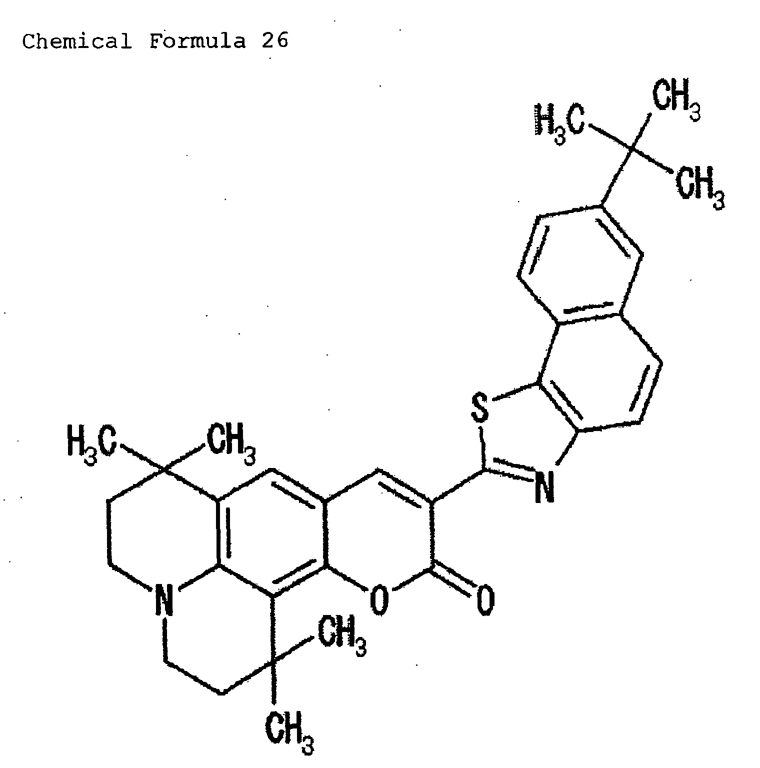

The phosphorescent material is a material having phosphorescent properties, and emits light in shifting to the basis state from the excited state. The phosphorescent material shifts to the basis state when obtaining the energy from the host, and can extract the light emission from a singlet and triplet in the excited state at room temperature. Alternatively, the phosphorescent material shifts to the excited state when the holes and electrons transported from the host recombine with each other. An amount of the phosphorescent material with respect to that of the host is preferably at least 0.01% by weight and is preferably no more than 30% by weight.

Examples of the phosphorescent material include factris(2-phenylpyridine)iridium, bis(2-phenylpyridinato-N,C2')iridium(acetylacetonate), 6-di(fluorophenyl)-pyridinate-N,C2')iridium(acetylacetonate), iridium(III)bis[4,6-di(fluorophenyl)-pyridinate-N,C2']picolinate, platinum(II)(2-(4',6'-difluorophenyl)pyridinate N,C2')(2,4-pentanedionate), platinum(II)(2-(4',6'-difluorophenyl)pyridinate N,C2')(6-methyl-2,4-heptanedionate-O,O), and bis(2-(2'-benzo[4,5-a]thienyl)pyridinate-platinum(II)(2-(4',6'-difluorophenyl)pyridinate N,C3')iridium(acetylacetonate).

In general, a phosphorescent heavy metal complex is used as the phosphorescent material in many cases. For example, tris(2-phenylpyridine)iridium having green phosphorescent and 2,3,7,8,12,13,17,18-octaethyl-21H23H-prophin platinum(II) having red phosphorescent is also used as the phosphorescent material. A central metal in these materials may be changed to another metal or nonmetal.

The light emitting layer may be formed on the hole injection transport layer by the known thin-film forming methods such as a vacuum vapor deposition method, a spin coating method, a casting method, and a LB method.

Depending on the type of the material forming the light emitting layer, the thickness of the light emitting layer is preferably 1 to 100 nm, more preferably 2 to 50 nm.

When the single layer of the light emitting layer includes a plurality of dopants, the light emitting layer emits light having mixed colors, or emits two or more light beams. When the single layer of the light emitting layer includes a first dopant that has a lower energy level compared with that of the host and a second dopant that has a lower energy level compared with that of the first dopant, the energy moves from the host to a first dopant, and subsequently moves from the first dopant to the second dopant.

With the use of the mechanism in which the host transports the carrier to the dopant and causes the recombination of the transported carrier in the dopant, the efficiency of carrier movement can be improved.

It is to be noted that chromaticity, chroma, lightness, luminance, and the like of the light emitted from the light emitting layer may be adjusted by selection of the type of material forming the light emitting layer, adjustment of the added amount of the dopant, and adjustment of the thickness of the light emitting layer.

As described above, the light emitting layer may have a laminate structure, and each layer may emit light having a wavelength different from that of at least another layer. When the light emitting layer has the following laminate structure, the light emitting layer can emit white light.
(1) red light emitting layer/blue light emitting layer/green light emitting layer;
(2) red light emitting layer/green light emitting layer/blue light emitting layer;
(3) green light emitting layer/blue light emitting layer/red light emitting layer;
(4) green light emitting layer/red light emitting layer/blue light emitting layer;
(5) blue light emitting layer/red light emitting layer/green light emitting layer;
(6) blue light emitting layer/green light emitting layer/red light emitting layer;
(7) red and green light emitting layer/blue light emitting layer;
(8) blue light emitting layer/red and green light emitting layer;
(9) red light emitting layer/green and blue light emitting layer;
(10) green and blue light emitting layer/red light emitting layer;
(11) red and blue light emitting layer/green light emitting layer;
(12) green light emitting layer/red and blue light emitting layer; or
(13) red, green and blue light emitting layer(white light emitting layer)

The layers in each of the examples of the light emitting layer are arranged in order from the side facing the anode toward the cathode.

The light emitting layer may be constituted to emit light that has colors in a complementary color relation like blue and yellow, light blue and orange, and green and purple. In this case, the light emitting layer as a whole emits white light. Needless to say, the light emitting layer may be constituted to emit light that has a color other than white.

For the blue light emitting layer, preferably, a dopant whose emission color is blue and host are mixed, for example, by co-vapor deposition, and the blue light emitting layer is formed on the cathode side from the red and green light emitting layers.

Examples of a dopant whose emission color is blue include distyrylamine derivatives, pyrene derivatives, perylene derivatives, anthracene derivatives, benzoxazole derivatives, benzothiazole derivatives, benzimidazole derivatives, chrysene derivatives, phenanthrene derivatives, distyryl benzene derivatives, and tetraphenyl butadienes.

Examples of a host for the blue emission layer include distyrylarylene derivatives, stilbene derivatives, carbazole derivatives, triarylamine derivatives, anthracene derivatives, pyrene derivatives, coronene derivatives, and bis(2-methyl-8-quinolinolato)(p-phenylphenolato)aluminum (BAlq).

Examples of a dopant whose emission color is red include europium complex, benzopyrane derivatives, rhodamine derivatives, benzothioxanthene derivatives, porphyrin derivatives, nailered, 2-(1,1-dimethylethyl)-6-(2-(2,3,6,7-tetrahydro-1,1,7,7-tetramethyl-1H,5H-benzo(ij)quinolidin-9-yl)ethenyl)-4H-pyran-4H-ylidene)propanedinitrile (DCJTB), and DCM.

Examples of a dopant whose emission color is green include coumarin derivatives and quinacridone derivatives.

Examples of a host for the red light emitting layer and green light emitting layer include distyrylarylene derivatives, distyrylbenzene derivatives, distyrylamine derivatives, quinolinolato-based metal complex, triarylamine derivatives, oxadiazole derivatives, silole derivatives, dicarbazole derivatives, oligothiophene derivatives, benzopyran derivatives, triazole derivatives, benzoxazole derivatives, and benzothiazole derivatives. Preferable examples of the host include Alq3, tetramer of triphenylamine, and 4,4'-bis(2,2'-diphenylvinyl)biphenyl (DPVBi).

For a light emitting layer that emits a plurality of colors such as red and blue light, a dopant that emits the respective colors and host may be mixed by co-vapor deposition.

The technique of adjusting the emission color of the light emitting layer include the following (1) to (3). One or a plurality of the techniques among these may be used to adjust the emission color.
(1) A technique of disposing color filters. The color filters limit the wavelength transmitted to adjust the emission color. As for the color filters, for example, known materials are used: cobalt oxide is used as blue filters, a mixed material of cobalt oxide and chromium oxide is used as green filters, and iron oxide is used as red filters. In this manner, color filters may be formed using known thin-film forming methods, such as the vacuum vapor deposition method.
(2) A technique of adding, to the light emitting layer, a material for promoting or inhibiting light emission. For example, when a so-called assistant dopant is added, which receives energy from the host and which moves the energy into the dopant, the energy is easily moved into the dopant from the host. The assistant dopant may be selected from the materials described as examples of the host and dopant.
(3) A technique of adding a material for converting the wavelength of the light emitted by the light emitting layer. Examples of this material include a fluorescent conversion material for converting the light into another light having a low energy wavelength. The type of the fluorescent conversion material is appropriately selected in accordance with the targeted wavelength of the light to be emitted from the organic EL device and the wavelength of the light emitted from the light emitting layer. An amount of the fluorescent conversion material added is appropriately selected in such a range that concentration extinction does not occur in accordance with the type of material, but an amount of about 10⁻⁵ to 10⁻⁴ mol/liter is preferable with respect to an uncured transparent resin. Only one type of fluorescent conversion material may be used, or a plurality of types may also be used. With the combined use of a plurality of types, by the combination, in addition to the blue, green, and red lights, a white color or a neutral-color light can be emitted. Examples of fluorescent conversion materials include the following materials (a) to (c).
   (a) Concrete examples of fluorescent conversion materials excited by an ultraviolet ray to emit blue light include stilbene based pigments such as 1,4-bis(2-methylstyrene)benzene and trans-4,4'-diphenyl stilbene; coumarin based pigments such as 7-hydroxy-4-methyl coumarin; and aromatic dimethylidine based pigment such as 4,4-bis(2,2-diphenylvinyl)biphenyl.
   (b) Concrete examples of fluorescent conversion materials excited by blue light to emit green light include coumarin pigments such as 2,3,5,6-1H,4H-tetrahydro-8-trifluoromethyl quinolidino(9,9a,1-gh)coumarin (coumarin153).
   (c) Concrete examples of fluorescent conversion materials excited by light having wavelengths of blue to green to emit light having wavelengths of orange to red include cyanine based pigments such as 4-(dicyanomethylene)-2-methyl-6-(p-dimethylaminostyrylryl)-4H-pyran, 4-(dicyanomethylene)-2-phenyl-6-(2-(9-julolidyl)ethenyl)-4H-pyran, 4-(dicyanomethylene)-2,6-di(2-(9-julolidyl)ethenyl)-4H-pyran, and 4-(dicyanomethylene)-2-methyl-6-(2-(9-julolidyl)ethenyl)-4H-pyran and 4-(dicyanomethylene)-2-methyl-6-(2-(9-julolidyl)ethenyl)-4H-thiopyran; pyridine based pigments such as 1-ethyl-2-(4-(p-dimethylaminophenyl)-1,3-butadienyl)-pyridium-perchlorate (pyridine 1); xanthine based pigments such as rhodamine B and rhodamine 6G; and oxazine based pigments.

### <<Electron Injection Transport Layer>>

The electron injection transport layer, which is disposed between the cathode and the light emitting layer, transports the electrons injected from the cathode to the light emitting layer.

The electron injection transport layer imparts the following properties to the organic EL device.
(1) Driving voltage drops.
(2) Injection of the electron into the light emitting layer from the cathode is stabilized. Therefore, life of the device is extended.
(3) Adhesion between the cathode and the light emitting layer increases. Therefore, uniformity of the light emitting surface is improved.
(4) Protrusions on the surface of the cathode are coated. Therefore, device defects can be reduced.

A material for forming the electron injection transport layer is arbitrarily selected from the known materials which can be used as the electron injection material of the photoconductive device and the known material used in the electron injection transport layer of a conventional organic EL device. In general, a material is used whose electron affinity is between the work function of the cathode and the electron affinity of the light emitting layer.

Concrete examples of a material for forming the electron injection transport layer include oxadiazole derivatives such as 1,3-bis[5'-(p-tert-butylphenyl)-1,3,4-zzol-2'-yl]benzene and 2-(4-biphenylyl)-5-(4-t-butylphenyl)-1,3,4-oxadiazole; triazole derivatives such as 3-(4'-tert-butylphenyl)-4-phenyl-5-(4''-biphenyl)-1,2,4-triazole; triazine derivatives; perylene derivatives; quinoline derivatives; quinoxaline derivatives; diphenylquinone derivatives; nitro substituted fluorenone derivatives; thiopyran dioxide derivatives; anthraquinodimethane derivatives; thiopyran dioxide derivatives; heterocyclic tetracarboxylic acid anhydrides such as naphthalene perylene; carbodiimide; fluorenylidene methane derivatives; anthraquinodimethane derivatives; anthrone derivatives; distyryl pyrazine derivatives; silole derivatives; phenanthroline derivatives; imidazopyridine derivatives; organic metal complexes such as bis(10-benzo[h]quinolinolate)beryllium, beryllium salt of 5-hydroxyflavone, and aluminum salt of 5-hydroxyflavone; and metal complex of 8-hydroxyquinoline or its derivatives such as metal chelate oxynoid compounds containing a chelate of oxine (e.g. 8-quinolinol or 8-hydroxyquinoline). Examples of the metal chelate oxynoid compounds include tris(8-quinolinol)aluminium, tris(5,7-dichloro-8-quinolinol)aluminium, tris(5,7-dibromo-8-quinolinol)aluminium, and tris(2-methyl-8-quinolinol)aluminium. The examples also include a metal complex in which the central metal of the above-described metal complex is replaced with indium, magnesium, copper, calcium, tin, zinc, or lead. A metal-free complex, metal phthalocyanine, or a complex in which the terminal is substituted by an alkyl group, or sulfone group is also preferably used.

The electron injection transport layer may be formed of only one of the above-described materials, or a mixture of a plurality of materials. The electron injection transport layer may also have a multilayered structure constituted of a plurality of layers of the same composition or different compositions.

The electron injection transport layer may be formed by known thin-film forming methods such as a sputtering process, an ion plating method, a vacuum vapor deposition method, a spin coating method, and an electron beam vapor deposition method. The thickness of the electron injection transport layer is preferably 5 nm to 5 µm.

It is to be noted that when the electron injection transport layer is disposed on the light extraction side from the light emitting layer, the layer needs to be transparent with respect to the light to be extracted. The transmittance with respect to the light to be extracted is preferably higher than 10%.

### <<Other Layers and Additives>>

In an organic EL device according to the present embodiment, the known layers other than the above-described layers may also be disposed, or known additives such as dopants may also be added to the constituting layers.

For example, when the layers described above in the layer constitution examples, such as the electron transport layer, hole transport layer, and hole injection layer, are disposed, the functions to be borne by these layers (carrier transport function, carrier injection function) are noted, an appropriate material is selected from the above-described materials, and the layers may be prepared in the same manner as in the above-described layers.

A layer for enhancing the adhesion between the layers or enhancing electron or hole injection properties may also be disposed. For example, a cathode interface layer (mixed electrode) obtained by the co-vapor deposition of the material forming the cathode and the material forming the electron injection transport layer may also be disposed between the layers. Accordingly, an energy barrier of electron injection existing between the light emitting layer and the cathode is alleviated. The adhesion between the cathode and the electron injection transport layer is also enhanced.

The material for forming the cathode interface layer is not especially limited as long as the material imparts the above-described capabilities to the cathode interface layer. Examples of such material include fluoride, oxide, chloride, and sulfide of alkaline metal and alkaline earth metal such as lithium fluoride, lithium oxide, magnesium fluoride, calcium fluoride, strontium fluoride, and barium fluoride. The cathode interface layer may be formed of either a single material or a plurality of materials.

The thickness of the cathode interface layer is preferably 0.1 nm to 10 nm, more preferably 0.3 nm to 3 nm. As to the thickness of the cathode interface layer, the layer may be formed to be uniform, non-uniform, or insular, and may be formed by known thin-filter forming methods, such as the vacuum vapor deposition method.

In at least one of the above-described interlayers, a layer (block layer) for inhibiting movement of the holes, electrons, or exciton may also be used. For example, a hole block layer may be disposed adjacent to the cathode side of the light emitting layer for the purpose of inhibiting the passage of the hole through the light emitting layer and efficiently recombining the electron in the light emitting layer. Examples of the material for forming the hole block layer include known materials such as triazole derivatives, oxadiazole derivatives, BAlq, and phenanthroline derivatives, but the material is not limited to these.

Alternatively or additionally, a layer (buffer layer) for alleviating the injection barrier of the holes and electrons may be disposed in at least one of the interlayers. For example, the buffer layer may also be inserted between the anode and hole injection transport layer or between the organic layers laminated adjacent to the anode for the purpose of alleviating the injection barrier with respect to the hole injection. As the material for forming the buffer layer, known materials, such as copper phthalocyanine are used, but this is not especially limited.

Instead of the glass cover, a seal layer or passivation film may be disposed on the side of the organic EL device 10 opposite to the substrate 11 for the purpose of preventing the organic layer 13 from contacting oxygen or moisture. Examples of material for forming the seal layer include organic polymeric materials, inorganic materials, and photo-setting resin, and which material may be used alone or as a combination of a plurality of materials. The above-described fluorescent conversion material may be added to the material for forming the seal layer. The seal layer may also have either a mono-layer structure or a multilayered structure.

Examples of the organic polymeric material include fluorine based resin of copolymers such as chlorotrifluoroethylene polymer, dichlorodifluoroethylene polymer, and copolymer of chlorotrifluoroethylene and dichlorodifluoroethylene; acrylic resin such as polymethyl methacrylate and polyacrylate; epoxy resin; silicone resin; epoxy silicone resin; polystyrene resin; polyester resin; polycarbonate resin; polyamide resin; polyimide resin; polyamideimide resin; polyparaxylene resin; polyethylene resin; and polyphenylene oxide resin. Examples of the inorganic material include polysilazane, diamond thin film, amorphous silica, electrically insulating glass, metal oxide, metal nitride, metal carbide, and metal sulfide.

The organic EL device may also be sealed and protected in inactive materials such as paraffin, liquid paraffin, silicone oil, fluorocarbon oil, and zeolite added fluorocarbon oil.

Needless to say, the organic EL device may be protected by can sealing. Concretely, for a purpose of cutting off moisture or oxygen from the outside, the organic layer may be sealed by seal members such as a seal plate and a seal container. The seal member may be disposed only on the rear-surface side (electrode side) of the organic EL device, or the whole organic EL device may also be coated with the seal member. When the organic layer can be sealed and the outside air can be cut off, the shape, size, or thickness of the seal member is not especially limited. Examples of the material for forming the seal member include glass; metal such as stainless steel and aluminum; plastic such as polychlorotrifluoroethylene, polyester, polycarbonate; and ceramic.

When the seal member is disposed in the organic EL device, a sealant or an adhesive may also be used. When the whole organic EL device is coated with the seal member, instead of using the sealant, the seal members may be mutually thermally bonded. Examples of the sealant include an ultraviolet setting resin, thermally setting resin, and two-liquids type setting resin.

Furthermore, a moisture absorbent or inactive solution may also be inserted in a space between the sealed container and the organic EL device. Examples of the moisture absorbent include barium oxide, sodium oxide, potassium oxide, calcium oxide, sodium sulfate, calcium sulfate, magnesium sulfate, phosphorus pentoxide, calcium chloride, magnesium chloride, copper chloride, cesium fluoride, niobium fluoride, calcium bromide, vanadium bromide, molecular sieve, zeolite, and magnesium oxide. Examples of the inactive solution include paraffin; liquid paraffin; fluorine-based solvent such as perfluoroalkane, perfluoroamine, and perfluoroether; chlorine-based solvent; and silicone oil.

The hole injection transport layer or the electron injection transport layer may be doped with organic emission materials or dopants such as a fluorescent material and phosphorescent material to emit the light.

When the cathode is formed of metal such as aluminum, the portion of the organic layer disposed adjacent to the cathode may be doped with alkaline metal or an alkaline metal compound in order to alleviate the energy barrier between the cathode and the organic layer. Since the organic layer is reduced by the added metal or metal compound to produce anions, the electron injection properties are enhanced, and the applied voltage drops. Examples of the alkaline metal compound include oxide, fluoride, and lithium chelate.

The present examples and embodiments are to be considered as illustrative and not restrictive and the invention is not to be limited to the details given herein, but may be modified within the scope and equivalence of the appended claims.

An organic electroluminescent device of the present invention includes a substrate, an anode, an organic layer having a light emitting layer, and a cathode capable of transmitting light. The cathode has an electron injection layer of calcium and a protective layer of silver. The protective layer covers the surface of the electron injection layer.

## Claims

1. An organic electroluminescent device **characterized by**:
a substrate;
an anode and a cathode each located on or above the substrate, wherein one of the anode and the cathode is located above the other one; and
an organic layer located between the anode and the cathode, wherein the organic layer having at least a light emitting layer;
wherein the cathode has an electron injection layer and a protective layer, the electron injection layer has a first surface and a second surface, the first and second surfaces are on opposite sides of the electron injection layer, the first surface faces the organic layer, the second surface faces away from the organic layer, the protective layer covers the second surface to protect the electron injection layer, the electron injection layer is made of pure metal, metal alloy, or a metal compound, and the protective layer is made of pure metal or metal alloy.

2. The organic electroluminescent device according to claim 1, **characterized in that** the cathode has resistivity that is no more than resistivity of another cathode that is made of indium tin oxide and is similar in shape and size to said cathode.

3. The organic electroluminescent device according to claim 1, **characterized in that** wherein the cathode has a sheet resistivity that is more than 0 Q/sheet and is no more than 10 Ω/sheet.

4. The organic electroluminescent device according to any one of claims 1 to 3, **characterized in that** the cathode is located above the anode, wherein the cathode is capable of transmitting light, and wherein light emitted by the light emitting layer is outputted from the organic electroluminescent device through the cathode.

5. The organic electroluminescent device according to any one of claims 1 to 3, **characterized in that** the anode is located above the cathode, wherein the substrate and the cathode is capable of transmitting light, and wherein light emitted by the light emitting layer is outputted from the organic electroluminescent device through the cathode and the substrate.

6. The organic electroluminescent device according to any one of claims 1 to 5, **characterized in that** the electron injection layer and the protective layer are transparent.

7. The organic electroluminescent device according to any one of claims 1 to 6, **characterized in that** the organic layer includes a contiguous portion that is contiguous to the electron injection layer, and wherein the electron injection layer is made of a material that has a work function of no more than the absolute value of the lowest unoccupied molecular orbital level of the contiguous portion.

8. The organic electroluminescent device according to any one of claims 1 to 7, **characterized in that** the organic layer has a plurality of layers including a contiguous layer contiguous to the electron injection layer, and wherein the electron injection layer is made of a material that has a work function of no more than the absolute value of the lowest unoccupied molecular orbital level of the contiguous layer.

9. The organic electroluminescent device according to any one of claims 1 to 8, **characterized in that** the electron injection layer includes alkaline metal or alkaline earth metal.

10. The organic electroluminescent device according to claim 9, **characterized in that** the electron injection layer is formed of calcium.

11. The organic electroluminescent device according to any one of claims 1 to 10, **characterized in that** the protective layer is made of a material that has resistivity lower than that of a material of which the electron injection layer is formed.

12. The organic electroluminescent device according to claim 11, **characterized in that** the protective layer is formed of silver.

13. The organic electroluminescent device according to any one of claims 1 to 12, **characterized in that** the protective layer has a thickness of 7 to 11 nm.

14. The organic electroluminescent device according to any one of claims 1 to 13, **characterized in that** the organic layer includes at least two light emitting layers in which the light emitting layers are operable for emitting light of different colors from one another.

15. The organic electroluminescent device according to claim 14, **characterized in that** the number of the light emitting layers is three.

16. The organic electroluminescent device according to claim 15, **characterized in that** the colors are green, blue, and red.
